# EUROPÄISCHE PATENTSCHRIFT

(11) **EP 1 099 118 B1**
(45) Veröffentlichungstag und Bekanntmachung des Hinweises auf die Patenterteilung: **24.09.2003**
(21) Anmeldenummer: 99942748.7
(22) Anmeldetag: 01.07.1999
(51) Int. Cl.: G01R 27/26, G06K 9/00

(54) **VERFAHREN ZUR BESTIMMUNG SEHR KLEINER KAPAZITÄTEN UND VERWENDUNG DAVON**
METHOD FOR DETERMINING VERY LOW CAPACITANCE AND THE USE THEREOF
PROCEDE POUR LA DETERMINATION DE TRES PETITES CAPACITES ET SON UTILISATION

(30) Priorität: 23.07.1998 DE 19833211
(43) Veröffentlichungstag der Anmeldung: 16.05.2001
(73) Patentinhaber: Micronas Munich GmbH, 81541 München (DE)
(72) Erfinder: VON BASSE, Paul-Werner, D-82515 Wolfratshausen (DE); WILLER, Josef, D-85521 Riemerling (DE)
(74) Vertreter: Patentanwälte Westphal, Mussgnug & Partner
(86) Internationale Anmeldenummer: DE9901930
(87) Internationale Veröffentlichungsnummer: WO00005592

(56) Entgegenhaltungen:
- SE-B- 448 408
- US-A- 4 039 940
- US-A- 5 343 157
- TARTAGNI M ET AL: "A FINGERPRINT SENSOR BASED ON THE FEEDBACK CAPACITIVE SENSING SCHEME" IEEE JOURNAL OF SOLID-STATE CIRCUITS,US,IEEE INC. NEW YORK, Bd. 33, Nr. 1, Seiten 133-142-142, XP000766627 ISSN: 0018-9200

## Beschreibung

Die vorliegende Erfindung betrifft ein Verfahren zur Bestimmung sehr kleiner Kapazitäten von elektrischen Bauelementen, das insbesondere bei kapazitiv messenden Oberflächensensoren, insbesondere bei Fingerabdrucksensoren, angewendet werden kann.

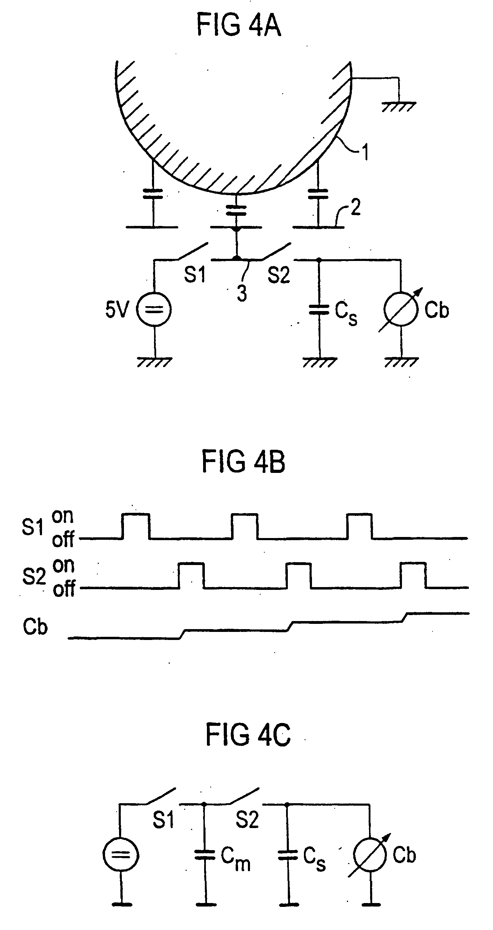

Sehr kleine Kapazitäten können dadurch bestimmt werden, daß die Kapazität mehrfach aufgeladen wird und die Ladung jeweils auf einer größeren Kapazität gesammelt wird. Von der Größe der gesammelten Ladung bei einer bestimmten Anzahl von Ladevorgängen kann auf die kleine Kapazität rückgeschlossen werden. Dieses Verfahren kann z. B. bei einem kapazitiv messenden Fingerabdrucksensor angewendet werden. Eine Anordnung von Leitern und elektrischen Schaltungskomponenten, die dafür geeignet sind, sind im Schema in Figur 4 dargestellt. Zur Aufnahme eines vollständigen Bildes, z. B. eines Fingerabdrucks, wird eine rasterförmige Anordnung von Leiterflächen verwendet, die mit einer Abdeckung und einer Auflagefläche für die Fingerkuppe versehen ist. Durch den unterschiedlichen Abstand der Leiter von der als geerdet anzunehmenden Hautoberfläche ergeben sich unterschiedliche Kapazitäten. Die Kondensatoren, die durch die Leiter und die im Abstand dazu angeordneten Bereiche der Hautoberfläche gebildet werden, werden daher bei Anlegen einer gleichen Potentialdifferenz unterschiedlich stark aufgeladen. Diese Ladungen sind ein Maß für die Kapazität zur Hautoberfläche und können daher zur Aufnahme des Fingerabdruckes dienen. Um die sehr kleinen Ladungen messen zu können, werden sie nach mehreren Ladeyorgängen jeweils auf einer größeren Kapazität gesammelt und gemessen.

In Figur 4a ist die Oberfläche 1 des zu erfassenden Bildes im Abstand zu den der Bildoberfläche zugewandten Leiterflächen 2 im Querschnitt dargestellt. Diese Leiterfläche 2 ist mit der Leitung 3 verbunden und wirkt als Kondensatorplatte gegenüber der Oberfläche 1 des zu erfassenden Bildes. Sie kann über die Schalter S1 und S2 alternativ mit einer Gleichspannungsquelle, die hier im Beispiel eine Spannung von 5 Volt liefert, und mit einem Kondensator Cₛ, der als Sammelkapazität fungiert, verbunden werden. Die auf diesem Kondensator Cₛ gesammelte Ladung wird mit dem eingezeichneten Coulombmeter Cb gemessen.

In Figur 4b sind die Schaltsignale, mit denen die Schalter S1 und S2 betätigt werden, sowie die von dem Coulombmeter gemessenen Ladungen als Funktion der Zeit dargestellt.

In Figur 4c ist ein elektrisches Ersatzschaltbild für die Anordnung aus Figur 4a dargestellt.

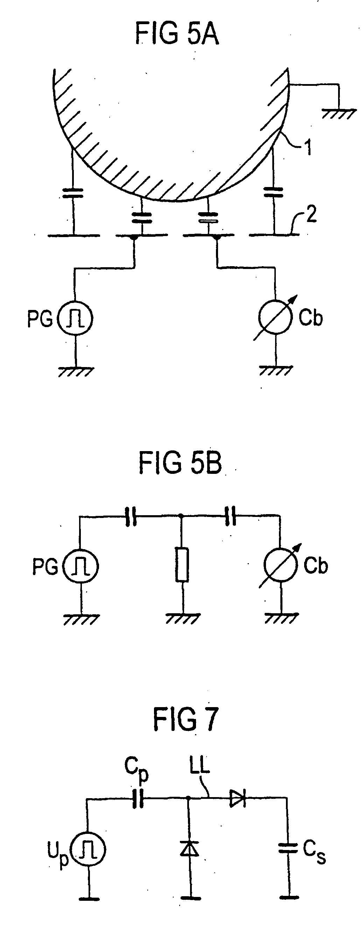

Statt die Ladung eines Kondensators zu messen, der durch Leiterflächen in zwei verschiedenen Ebenen gebildet wird, kann man die Kapazitäten zweier Leiterflächen in derselben Ebene messen. Vorzugsweise wählt man dazu jeweils zwei benachbart zueinander angeordnete Leiterflächen. Diese Leiter werden durch die aufliegende Oberseite des Bildes, z.B. die Hautoberfläche, miteinander verkoppelt. Auch hier wird die kapazitive Verkopplung um so stärker, je geringer der Abstand der Hautoberfläche zu den Leiterflächen wird. In einem Ladungsmeßgerät wird die übertragene Ladung gemessen. Die zugehörige Sensoranordnung und das elektrische Ersatzschaltbild sind in den Figuren 5a und 5b dargestellt. Bei diesem Verfahren genügt daher die Verwendung einer einzigen strukturierten Leiterebene, die praktisch nur aus einem Feld von Leiterflächen mit sich kreuzenden Leitungen besteht. Da die Leiter nicht mit aktiven Bauelementen in unmittelbarer Nähe verbunden werden müssen, lassen sie sich auf isolierenden Folien unterbringen. Die Ladungen, die man bei der Anwendung dieses Verfahrens erhält, sind aber wesentlich kleiner als bei dem anhand der Figur 4 beschriebenen.

Das Ladungsmeßgerät besteht vorzugsweise aus einem Verstärker. Wird noch ein Analog-digital-Wandler nachgeschaltet, um eine digitale Auswertung der Messung vornehmen zu können, benötigen dieser Verstärker und dieser Analog-digital-Wandler viel Fläche, was dazu führt, daß nur ein Bildpunkt angesteuert und ausgelesen werden kann. Alle übrigen Steuerleitungen und Leseleitungen müssen niederohmig festgehalten werden, was in Figur 6 in einer schematischen Aufsicht auf die Leiterflächenanordnung gezeigt ist. Die Ansteuerleitungen sind hier die senkrechten Verbindungen der einzelnen quadratischen Leiterflächen. Die Leseleitungen verlaufen waagerecht. An den Kreuzungspunkten sind die Ansteuerleitungen und die Leseleitungen gegeneinander isoliert. Die kapazitiven Verkoppelungen sind durch die runden Pfeile angedeutet. Ein vergleichbarer Fingerabdrucksensor ist in der SE 448408 beschrieben. Bei dieser Art der Ansteuerung erreicht man, daß nur eine Ansteuerleitung kapazitiv auf die Leitungen überkoppelt. Damit aber die Leseleitungen nicht wechselseitig aufeinander überkoppeln, müssen alle Leseleitungen niederohmig festgehalten werden, was z. B. durch Schalter oder durch den niederohmigen Eingangswiderstand des Verstärkers erreicht werden kann.

In Figur 7 ist eine Schaltung dargestellt, mit der ein Pumpverfahren von Ladungen mit einer seriellen Kapazität, wie es auch bei Spannungsvervielfachern benutzt wird, durchgeführt werden kann.

Aufgabe der vorliegenden Erfindung ist es, ein Verfahren zur Bestimmung sehr kleiner Kapazitäten einer rasterförmigen Anordnung von Kondensatoren anzugeben. Dieses Verfahren soll insbesondere zur Bilderfassung, z. B. von Fingerabdrücken geeignet sein.

Diese Aufgabe wird mit dem Verfahren mit den Merkmalen des Anspruches 1 gelöst. Ausgestaltungen, insbesondere die Verwendung des Verfahrens zur Bilderfassung, ergeben sich aus den abhängigen Ansprüchen.

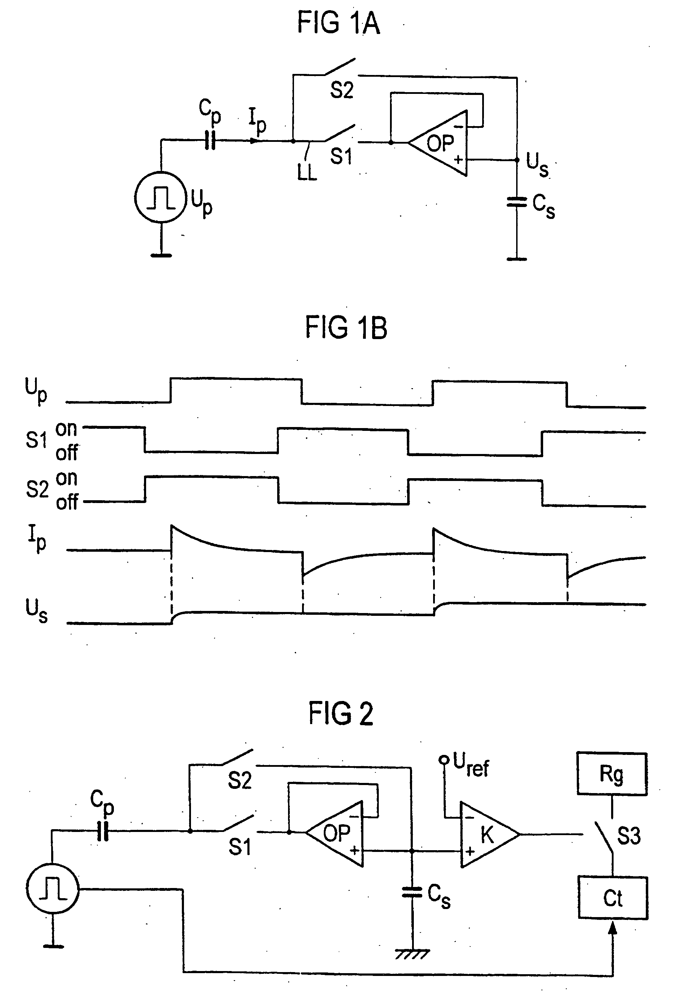

Bei dem erfindungsgemäßen Verfahren werden alle Leseleitungen (die Leitungen LLₙ₋₁, LLₙ, LLₙ₊₁ in Figur 6) gleichzeitig ausgelesen. Der Meßwert aus jeder Leseleitung wird schon während des Meßvorganges digitalisiert. Dazu wird das Pumpverfahren mit einer seriellen Kapazität gemäß Figur 1a verwendet. Um die Überkopplung von Leseleitung zu Leseleitung zu unterdrükken, werden die beiden Dioden durch zwei Schalter und einen Operationsverstärker ersetzt. Diese Schalter S1, S2 und der Operationsverstärker OP sind in dem Schaltschema der Figur 1a eingezeichnet. In Figur 1b ist die zeitliche Abfolge der generierten Spannung Up und die Schaltsignale der Schalter S1 und S2 sowie des Stromes Ip und der Spannung am Kondensator Uₛ eingezeichnet. Kurz vor der positiven Flanke des Generatorsignales Up werden die beiden Schalter S1, S2 umgeschaltet. Die Kapazität Cp wird jetzt direkt mit der Sammelkapazität Cₛ verbunden. Mit der positiven, d.h. ansteigenden Flanke der generierten Spannung Up wird die Ladung von dem Kondensator Cp auf den Sammelkondensatpr Cₛ übertragen, wobei die Kapazität des Sammelkondensators Cₛ wesentlich größer ist als die Kapazität des Kondensators Cp. Die Spannung Uₛ steigt um einen kleinen Betrag an. Sobald der Strom Ip abgeklungen ist, werden die Schalter wieder umgeschaltet. Jetzt ist die Kapazität Cp mit dem Ausgang des Operationsverstärkers OP verbunden. Dieser rückgekoppelte Operationsverstärker überträgt die Spannung Uₛ an dem Sammelkondensator Cₛ direkt im Verhältnis 1:1 an seinen Ausgang. Nach dem Umschalten der Schalter folgt die negative, d.h. abfallende Flanke der generierten Spannung Up. Über den niederohmigen Ausgang des Operationsverstärkers wird der Kondensator Cp wieder aufgeladen, ohne daß Ladung von dem Sammelkondensator Cₛ abfließt. Daher kann nach nochmaligem Umschalten der Schalter der Entladevorgang von dem Kondensator Cp auf den Sammelkondensator Cₛ wiederholt werden. Dieser Ablauf wird im folgenden als Pumpzyklus bezeichnet. Während des Pumpzyklus ändert sich die Spannung auf der Leseleitung nur wenig, so daß kein Überkoppeln von einer Leseleitung auf die andere zu befürchten ist. Daher können mit diesem Verfahren alle Leseleitungen eines Feldes aus Bildpunkten über eine Steuerleitung (Leitungen SLₖ₋₂, SLₖ₋₁, SLₖ, SLₙ₊₁ in Figur 6) gepumpt werden und alle Leseleitungen ausgewertet werden.

Vorzugsweise wird das Verfahren so ausgeführt, daß die Sammelkondensatoren Cₛ bis zu einem vorgegebenen Wert aufgeladen werden, das Überschreiten dieses vorgegebenen Wertes durch einen Komparator anhand einer Referenzspannung U_{ref} festgestellt wird und die Anzahl der Pumpzyklen bis zu diesem Wert mit einem Zähler gezählt wird. Eine derartige Anordnung ist in Figur 2 dargestellt, worin mit Ct ein Zähler und mit Rg eine Registriereinheit bezeichnet sind. Der Schalter S3 dient dazu, den Zähler Ct alternativ an den Ausgang des Komparators K und an den Eingang der Registriereinheit anzuschließen. Auf diese Weise kann der Zähler gestoppt werden, wenn die Referenzspannung auf dem Sammelkondensator erreicht ist. Die von dem Zähler festgestellte Anzahl von Pumpzyklen kann nach dem Umschalten des Schalters S3 von der Registriereinheit gespeichert und/oder einer weiteren Auswertung zugeführt werden.

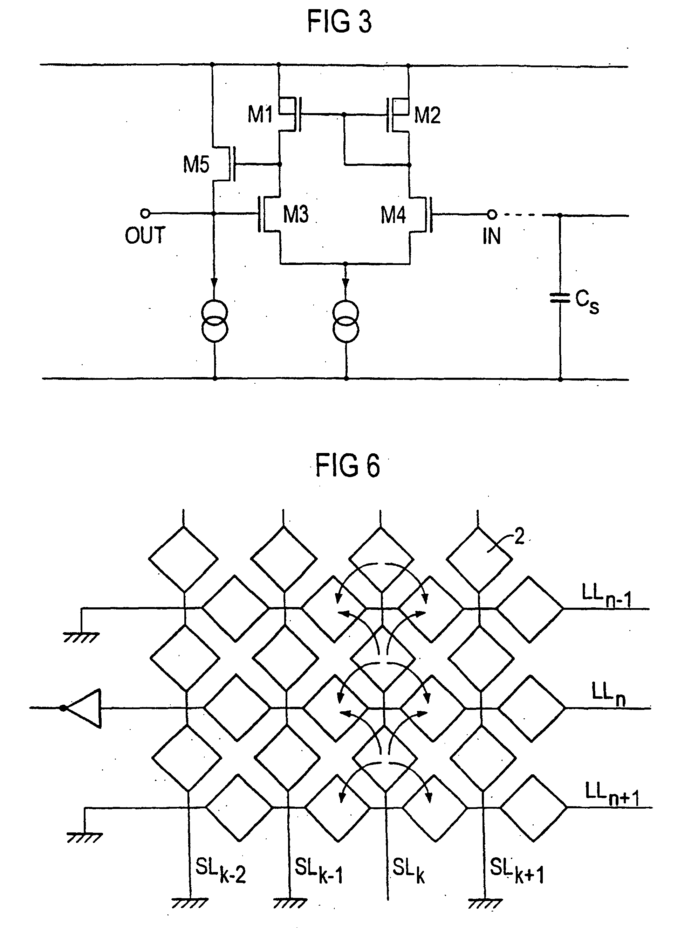

Figur 3 zeigt eine mögliche Ausgestaltung eines für das Verfahren geeigneten Operationsverstärkers, wie er in den Anordnungen gemäß den Figuren 1a und 2 verwendet werden kann. Andere Möglichkeiten, den Operationsverstärker zu realisieren sind aber nicht ausgeschlossen.

Vorteilhaft für das erfindungsgemäße Verfahren ist es, daß die kleinen zu messenden Ladungen bzw. an den Kondensatoren anliegenden Spannungen nicht direkt verstärkt werden, sondern durch Akkumulation bis zu einer vorgegebenen Grenze direkt in ein digitales Meßergebnis umgewandelt werden. Außerdem ist für das Verfahren vorteilhaft, daß jeweils eine Gruppe von zu messenden Kapazitäten gleichzeitig gemessen wird. Dabei kann es sich z. B. vorzugsweise um eine jeweilige Spalte in einer matrixförmigen Anordnung von Einzelkondensatoren handeln. Durch eine geeignete Schaltung, wie sie oben beschrieben wurde, kann erreicht werden, daß ein Überkoppeln zwischen den einzelnen Leseleitungen vermieden wird.

Das Pumpverfahren kann insbesondere auf einen Sensor angewandt werden, der über die Verkopplung zweier benachbarter Leiterflächen ein Bild kapazitiv erfaßt. Bei einem Fingerabdrucksensor, der im wesentlichen durch eine strukturierte Leiterebene gebildet wird, kann das Verfahren zur Messung der Pixelkapazität eingesetzt werden. Als Pixel bezeichnet man die kleinste Meßfläche des Sensors, also einen Bildpunkt. Je höher die Zahl der Pixel pro Flächeneinheit eines Sensors ist, desto besser ist seine Auflösung. Die Pixelabmessung bei einem Fingerabdrucksensor liegt in der Größenordnung von 50 µm bis 100 µm. Der Wert der Pixelkapazität ist umgekehrt proportional zum Abstand der Hautoberfläche des Fingers von der Leiterfläche. Daher ist die Anzahl n der Pumpzyklen bis zu einem bestimmten Referenzwert direkt proportional zum Abstand der Hautoberfläche von der Leiterfläche des Sensors.

Der Ladungshub ist Qp = Cp ΔUp.
Die gesammelte Ladung ist Qₛ = Cₛ Uₛ, wobei Uₛ höchstens so groß wird wie die Referenzspannung U_{ref}.
Da außerdem Qₛ = n Qp gilt, hat man für Uₛ = U_{ref} die Beziehung n = Qs/Qp.
Die Kapazität Cp ist umgekehrt proportional zum Abstand zwischen der Hautoberfläche des Fingers und der Leiterfläche; daher ist die Anzahl der Pumpzyklen proportional zu diesem Abstand.

Die Schaltung des Operationsverstärkers, des Komparators unddes Sammelkondensators ist so kompakt, daß sie in jeder Zeile der Anordnung einmal vorhanden sein kann. Ein eventueller Offset der Operationsverstärker wird durch das ständige Umschalten kompensiert.

## Patentansprüche

1. Verfahren zur Bestimmung sehr kleiner Kapazitäten einer rasterförmigen Anordnung von Kondensatoren (Cp), die aus Paaren elektrischer Leiterflächen (2) gebildet werden, bei dem
a) eine Aufteilung der Leiterflächen (2) in Gruppen vorgenommen wird,
b) die Leiterflächen (2) je einer Gruppe durch eine Leseleitung (LLₙ₋₁, LLₙ, LLₙ₊₁) elektrisch leitend miteinander verbunden werden,
c) die Leiterflächen (2) je einer Gruppe getrennt voneinander mit je einer Steuerleitung (SLₖ₋₁, SLₖ, SLₖ₊₁) elektrisch leitend verbunden werden,
d) an jeweils eine Steuerleitung während einer vorgegebenen Zeit ein elektrisches Potential derart angelegt wird, daß eine Potentialdifferenz zwischen der Steuerleitung und mehreren Leseleitungen auftritt, die die Kondensatoren (Cp), die aus je mindestens einer mit der Steuerleitung verbundenen Leiterfläche und je mindestens einer mit einer dieser Leseleitungen verbundenen Leiterfläche gebildet werden, auflädt,
e) die Ladung über jede Leseleitung gesondert auf je einen Sammelkondensator (Cₛ) abgeführt wird,
f) das an die Steuerleitung angelegte Potential abgeschaltet wird und mittels einer Schaltung ein jeweiliges Potential, das einen Ladezustand des betreffenden Sammelkondensators gegenüber einem Bezugspotential definiert, der betreffenden Leseleitung niederohmig eingeprägt wird,
g) die Schritte d bis f so oft wiederholt werden, bis eine vorgegebene Anzahl von Aufladungen stattgefunden hat oder bis an jedem Sammelkondensator (Cₛ) eine Potentialdifferenz anliegt, die größer ist als ein vorgegebener Wert, und
h) dann für jede Leseleitung die Ladung oder Potentialdifferenz des Sammelkondensators bzw. die Anzahl der Aufladungen bestimmt wird.

2. Verfahren nach Anspruch 1
bei dem in Schritt f je ein rückgekoppelter Operationsverstärker (OP) verwendet wird, der spätestens in dem Zeitpunkt, an dem das an die betreffende Steuerleitung angelegte Potential abgeschaltet wird, zwischen je einen zu messenden Kondensator (Cp) und den betreffenden Sammelkondensator (Cₛ) mit seinem Ausgang an die Leseleitung geschaltet wird.

3. Verfahren nach Anspruch 2
bei dem als Operationsverstärker (OP) eine Schaltung aus zwei p-Kanal-MOSFET (M1, M2) und drei n-Kanal-MOSFET (M3, M4, M5) verwendet wird,
wobei die Source-Anschlüsse der p-Kanal-MOSFET (M1, M2) und der Drain-Anschluß des ersten n-Kanal-MOSFET (M5) mit einem Anschluß einer Versorgungsspannung verbunden sind,
die Drain-Anschlüsse der p-Kanal-MOSFET mit den Drain-Anschlüssen je eines der zweiten und dritten n-Kanal-MOSFET (M3, M4) verbunden sind,
die Gate-Anschlüsse der p-Kanal-MOSFET miteinander und mit dem Drain-Anschluß des dritten n-Kanal-MOSFET verbunden sind,
die Source-Anschlüsse der zweiten und dritten n-Kanal-MOSFET miteinander und über eine Stromquelle mit dem anderen Anschluß der Versorgungsspannung verbunden sind,
der Gate-Anschluß des ersten n-Kanal-MOSFET mit dem Drain-Anschluß des zweiten n-Kanal-MOSFET verbunden ist,
der Source-Anschluß des ersten n-Kanal-MOSFET mit dem Gate-Anschluß des zweiten n-Kanal-MOSFET und über eine weitere Stromquelle mit dem anderen Anschluß der Versorgungsspannung verbunden ist und den Ausgang der Schaltung bildet und
der Gate-Anschluß des dritten n-Kanal-MOSFET den Eingang der Schaltung bildet.

4. Verwendung des Verfahrens nach einem der Ansprüche 1 bis 3 zur kapazitiven Bilderfassung mittels einer strukturierten Leiterfläche.

## Claims

1. A method for determining very small capacitances of a raster-shaped configuration of capacitors (Cp), which are formed from pairs of electrical conductor faces (2), in which
a) a division of the conductor faces (2) into groups is carried out,
b) the conductor faces (2) of a group are electrically conductively connected to each other by a read line (LLₙ₋₁, LLₙ, LLₙ₊₁),
c) the conductor faces (2) of group are electrically conductively connected separately from each other to a control line (SLₖ₋₁, SLₖ, SLₖ₊₁),
d) an electric potential is applied to a control line in each case during a predetermined period in such a manner that a potential difference occurs between the control line and several read lines, which charges the capacitors (Cp), which are formed from at least one conductor face connected to the control line and at least one conductor face connected to one of these read lines,
e) the charge is led away separately via each read line to a collective capacitor (Cs),
f) the potential applied to the control line is disconnected and by means of a circuit defines a respective potential which defines a charging state of the respective collective capacitor with respect to with a reference potential, which is impressed with low impedance onto the respective read line,
g) steps d to f are repeated until a predetermined number of charging operations has taken place or until there is a potential difference at each collective capacitor (Cₛ), which is larger than a predetermined value, and
h) then for each read line the charge or potential difference of the collective capacitor or the number of charging operations is determined.

2. A method according to Claim 1,
in which in step f a fed-back operational amplifier (OP) is used, which, at the latest in the instant at which the potential applied to the respective control line is switched off, is switched between a capacitor to be measured (Cp) and the respective collective capacitor (Cs) with its output to the read line.

3. A method according to Claim 2,
in which a circuit consisting of two p-channel MOSFETS (M1, M2) and three n-channel MOSFETS (M3, M4, M5) is used as the operational amplifier (OP),
whereby the source terminals of the p-channel MOSFET (M1, M2) and the drain terminal of the first n-channel MOSFET (M5) are connected to a connection of a supply voltage,
the drain terminals of the p-channel MOSFET are connected to the drain terminals of one of the second and third n-channel MOSFET (M3, M4),
the gate terminals of the p-channel MOSFET are connected to each other and to the drain terminal of the third n-channel MOSFET,
the source terminals of the second and third n-channel MOSFETs are connected to one another and via a current source to the other connection of the supply voltage,
the gate terminal of the first n-channel MOSFET is connected to the drain terminal of the second n-channel MOSFET,
the source terminal of the first n-channel MOSFET is connected to the gate terminal of the second n-channel MOSFET and via a further current source to the other connection of the supply voltage and forms the output of the circuit and the gate terminal of the third n-channel MOSFET forms the input of the circuit.

4. Use of the method according to one of Claims 1 to 3 for capacitive image recording by means of a structured conductor surface.

## Revendications

1. Procédé pour déterminer de très petites capacités d'une disposition quadrillée de condensateurs (Cp) formés en paires de surfaces conductrices électriques (2), selon lequel
a) les surfaces conductrices (2) sont réparties en groupes,
b) les surfaces conductrices (2) d'un groupe sont reliées électriquement les unes aux autres par une ligne de lecture (LLₙ₋₁, LLₙ, LLₙ₊₁)
c) les surfaces conductrices (2) d'un groupe séparées les unes des autres sont chacune reliées électriquement à une ligne pilote (SLₖ₋₁, SLₖ, SLₖ₊₁),
d) un potentiel électrique est appliqué sur chaque ligne pilote pendant un temps donné de sorte qu'une différence de potentiel se produit entre la ligne pilote et plusieurs lignes de lecture et charge les condensateurs (Cp) formés à partir d'au moins une surface conductrice reliée à la ligne pilote et au moins une surface conductrice reliée à l'une de ces lignes de lecture,
e) la charge a lieu séparément sur un condensateur collecteur (Cs) via chaque ligne de lecture,
f) le potentiel appliqué sur la ligne pilote est coupé et un potentiel définissant un état de charge du condensateur collecteur concerné par rapport à un potentiel de référence est appliqué à basse impédance à la ligne de lecture concernée via une commutation,
g) les étapes d) à f) sont répétées jusqu'à ce qu'un nombre prédéfini de charges ait lieu ou jusqu'à ce qu'une différence de potentiel supérieure à la valeur donnée soit appliquée sur chaque condensateur (Cs) et
h) la charge ou la différence de potentiel du condensateur collecteur ou le nombre de charges est défini pour chaque ligne de lecture.

2. Procédé selon la revendication 1,
selon lequel
à l'étape f, on utilise un amplificateur opérationnel (OP) réinjecté qui est connecté avec sa sortie à la ligne de lecture entre un condensateur (Cp) à mesurer et le condensateur collecteur (Cs) concerné, au plus tard lorsque le potentiel appliqué sur la ligne pilote concerné est coupé.

3. Procédé selon la revendication 2,
selon lequel
on utilise une commutation composée de deux p-canal-MOSFET (M1, M2) et de trois n-canal-MOSFET (M3, M4, M5), en tant qu'amplificateur opérationnel (OP), les connexions sources des p-canal-MOSFET (M1, M2) et la connexion drain du premier n-canal-MOSFET (M5) étant connectées à la connexion d'une tension d'alimentation, les connexions drain des p-canal-MOSFET étant connectées aux connexions drain du deuxième ou du troisième n-canal-MOSFET (M3, M4) les connexions grille des p-canal-MOSFET étant connectées les unes aux autres et à la connexion drain du troisième n-canal-MOSFET, les connexions source du deuxième et du troisième n-canal-MOSFET étant reliées les unes aux autres et à l'autre connexion de la tension d'alimentation via une source d'alimentation, la connexion grille du premier n-canal-MOSFET étant raccordée à la connexion drain du deuxième n-canal-MOSFET et à l'autre connexion de la tension d'alimentation via une autre source de courant, la connexion source du premier n-canal-MOSFET étant reliée à la connexion grille du deuxième n-canal-MOSFET et à l'autre connexion de la tension d'alimentation via une autre source de courant, et formant la sortie de connexion alors que la connexion grille du troisième n-canal-MOSFET forme l'entrée de la connexion.

4. Utilisation du procédé selon l'une des revendications 1 à 3, pour l'enregistrement de l'image en régime capacitif à l'aide d'une surface conductrice structurée.
